# EUROPEAN PATENT APPLICATION

(11) **EP 4 738 056 A1**
(43) Date of publication of application: **06.05.2026**
(21) Application number: 25211077.0
(22) Date of filing: 24.10.2025
(51) Int. Cl.: G06F 1/16, H04M 1/02

(54) **ELECTRONIC DEVICES WITH DISPLAYS**

(30) Priority: 30.10.2024 US 202463713996 P; 11.09.2025 US 202519326570
(71) Applicant: Apple Inc., Cupertino, CA 95014 (US)
(72) Inventor: STRYKER, James A., Campbell, (US); ROBINSON, Kevin M., Sunnyvale, (US); PARK, Daniel C., Redwood City, (US); GARELLI, Adam T., Morgan Hill, (US); HAMEL, Bradley J., Portola Valley, (US); CROOKS, Bradley S., Los Gatos, (US); HENDREN, Keith J., Santa Cruz, (US); CAO, Robert Y., San Francisco, (US); KRAHN, Scott J., Cupertino, 95014 (US); DERRY, Matthew, Mountain View, (US)
(74) Representative: Froud, Christopher Andrew

(57) **Abstract**

An electronic device (10) may include a flexible display (14) having first and second display portions (14P-1, 14P-2) that rotate relative to one another about a bend axis (28). The flexible display (14) may be mounted to a foldable housing (12) having first and second housing portions (60) coupled by a hinge (30) that is aligned with the bend axis (28). The foldable housing (12) is operable in a flat state and a folded state. A translation assembly (306) may be configured to slide the display (14) relative to the housing (12) as the device (10) moves between flat and folded states. A compression assembly (42) may be used to apply compression to the flexible display (14) when the foldable housing (12) is in the folded state. A tension assembly (44) may be used to apply tension to the flexible display (14) when the foldable housing (12) is in the flat state. If desired, the translation (306), compression (42), and tension (44) assemblies may be combined into a module.

## Description

This application claims priority to U.S. patent application No. 19/326,570, filed September 11, 2025, and U.S. provisional patent application No. 63/713,996, filed October 30, 2024.

### Field

This relates generally to electronic devices and, more particularly, to electronic devices with displays.

### Background

Electronic devices often have displays. Portability may be a concern for some devices, which tends to limit available real estate for displays.

### Summary

An electronic device may include a flexible display having first and second display portions that rotate relative to one another about a bend axis. The flexible display may be mounted to a foldable housing having first and second housing portions coupled by a hinge that overlaps the bend axis. The foldable housing may be operable in a flat state and a folded state.

The electronic device may include one or more translation assemblies for driving movement of the display relative to the housing. For example, a translation assembly may be used to slide the display relative to the housing as the housing moves between an open (flat) state and a closed (folded) state. The translation assembly may include straps, springs, and/or linkages to slide the display relative to the housing during opening and closing of the electronic device.

A compression assembly may be used to apply compression to the flexible display when the foldable housing is in the folded state to push the flexible display into the hinge and thereby prevent tenting and lift-off of the display relative to the hinge. A tension assembly may be used to apply tension to the flexible display when the foldable housing is in the flat state to avoid wrinkles in the display. If desired, the tension and compression assemblies may be combined into a single module.

The foldable housing may have a roller hinge or any other suitable type of hinge. In a roller type hinge (sometimes referred to as a constant length hinge), the hinge length between the first and second housing portions may remain constant as the device is folded and unfolded, which creates an offset between the bend axis of the display and the bend axis of the hinge. The translation modules may be used to apply loads to the display (e.g., to apply tension to the display in the flat state to avoid wrinkles) while also being used to facilitate the display translation required due to the offset between the hinge's bend axis and the display's bend axis. In other hinge arrangements such as a teardrop type hinge, the bend axis of the display and the bend axis of the hinge are already aligned, so the primary function of the translation modules may be to apply tension to the display in the flat state and to facilitate display translation that is needed due to tolerances and/or reliability over time.

### Brief Description of the Drawings

FIG. 1 is a schematic diagram of an illustrative electronic device in accordance with some embodiments.
FIG. 2 is a perspective view of an illustrative electronic device with a display in accordance with some embodiments.
FIG. 3 is a side view of an illustrative electronic device in accordance with some embodiments.
FIG. 4 is a side view of an illustrative electronic device having a foldable display with translation assemblies, tension assemblies, and compression assemblies in accordance with some embodiments.
FIG. 5 is a side view of the electronic device of FIG. 4 showing how a tension assembly may apply tension to a foldable display in a flat state to eliminate creases in the display in accordance with some embodiments.
FIG. 6 is a side view of the electronic device of FIGS. 4 and 5 showing how a compression assembly may apply compression to a foldable display in a folded state to press the display against a hinge in accordance with some embodiments.
FIG. 7 is a top view of an illustrative electronic device having a foldable housing and one or more sets of tension and compression assemblies on opposing sides of a hinge in accordance with some embodiments.
FIG. 8 is a top view of an illustrative tension and compression assembly in accordance with some embodiments.
FIG. 9 is a graph showing how compression and tension forces applied to a foldable display change as the display moves from a flat state to a folded state in accordance with some embodiments.
FIG. 10 is a top view of an illustrative electronic device having a foldable housing and translation assemblies that include a pair of straps to drive display motion and a linkage to amplify the display motion in accordance with some embodiments.
FIG. 11 is a top view of an illustrative electronic device having a foldable housing and translation assemblies that include a strap and a return spring to drive display motion and a linkage to amplify the display motion in accordance with some embodiments.
FIG. 12 is a top view of an illustrative electronic device having a foldable housing and having translation assemblies that include straps coupled to a lever and sliders that slide within slots as the lever rotates in accordance with some embodiments.
FIG. 13 is a top view of an illustrative electronic device having a foldable housing and having translation assemblies that include straps and springs coupled to a lever and sliders that slide within slots as the lever rotates in accordance with some embodiments.
FIG. 14 is a top view of an illustrative electronic device having a foldable housing and having translation assemblies that include a spring coupled between crank levers in accordance with some embodiments.
FIG. 15 is a top view of an illustrative translation assembly that includes a four-bar linkage in accordance with some embodiments.
FIG. 16 is a top view of an illustrative tension assembly that includes a four-bar linkage in accordance with some embodiments.
FIG. 17 is a top view of illustrative tension and compression assemblies configured to apply tension and compression to a display in accordance with some embodiments.
FIG. 18 is a top view of an illustrative tension and compression assembly in which a lever travels more than a display to help relieve the display from compressive load when the display is in a closed position in accordance with some embodiments.
FIG. 19 is a top view of an illustrative tension and compression assembly that uses a spring loaded lever on one side to apply tension and compression to a display in accordance with some embodiments.

### Detailed Description

Electronic devices may be provided with displays. Displays may be used for displaying images for users. Displays may be formed from arrays of light-emitting diode pixels or other pixels. For example, a device may have an organic light-emitting diode display or a display formed from an array of micro-light-emitting diodes (e.g., diodes formed from crystalline semiconductor dies).

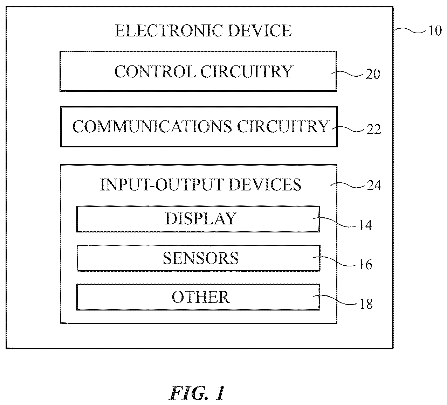

A schematic diagram of an illustrative electronic device having a display is shown in FIG. 1. Device 10 may be a cellular telephone, tablet computer, laptop computer, wristwatch device or other wearable device, a television, a stand-alone computer display or other monitor, a computer display with an embedded computer (e.g., a desktop computer), a system embedded in a vehicle, kiosk, or other embedded electronic device, a media player, or other electronic equipment. Configurations in which device 10 is a cellular telephone, tablet computer, or other portable electronic device may sometimes be described herein as an example. This is illustrative. Device 10 may, in general, be any suitable electronic device with a display.

Device 10 may include control circuitry 20. Control circuitry 20 may include storage and processing circuitry for supporting the operation of device 10. The storage and processing circuitry may include storage such as nonvolatile memory (e.g., flash memory or other electrically-programmable-read-only memory configured to form a solid state drive), volatile memory (e.g., static or dynamic random-access-memory), etc. Processing circuitry in control circuitry 20 may be used to gather input from sensors and other input devices and may be used to control output devices. The processing circuitry may be based on one or more microprocessors, microcontrollers, digital signal processors, baseband processors and other wireless communications circuits, power management units, audio chips, application specific integrated circuits, etc. During operation, control circuitry 20 may use a display and other output devices in providing a user with visual output and other output.

To support communications between device 10 and external equipment, control circuitry 20 may communicate using communications circuitry 22. Circuitry 22 may include antennas, radio-frequency transceiver circuitry (wireless transceiver circuitry), and other wireless communications circuitry and/or wired communications circuitry. Circuitry 22, which may sometimes be referred to as control circuitry and/or control and communications circuitry, may support bidirectional wireless communications between device 10 and external equipment over a wireless link (e.g., circuitry 22 may include radio-frequency transceiver circuitry such as wireless local area network transceiver circuitry configured to support communications over a wireless local area network link, near-field communications transceiver circuitry configured to support communications over a near-field communications link, cellular telephone transceiver circuitry configured to support communications over a cellular telephone link, or transceiver circuitry configured to support communications over any other suitable wired or wireless communications link). Wireless communications may, for example, be supported over a Bluetooth^{®} link, a WiFi^{®} link, a wireless link operating at a frequency between 6 GHz and 300 GHz, a 60 GHz link, or other millimeter wave link, cellular telephone link, wireless local area network link, personal area network communications link, or other wireless communications link. Device 10 may, if desired, include power circuits for transmitting and/or receiving wired and/or wireless power and may include batteries or other energy storage devices. For example, device 10 may include a coil and rectifier to receive wireless power that is provided to circuitry in device 10.

Device 10 may include input-output devices such as devices 24. Input-output devices 24 may be used in gathering user input, in gathering information on the environment surrounding the user, and/or in providing a user with output. Devices 24 may include one or more displays such as display 14. Display 14 may be an organic light-emitting diode display, a liquid crystal display, an electrophoretic display, an electrowetting display, a plasma display, a microelectromechanical systems display, a display having a pixel array formed from crystalline semiconductor light-emitting diode dies (sometimes referred to as microLEDs), and/or other display. Configurations in which display 14 is an organic light-emitting diode display or microLED display are sometimes described herein as an example.

Display 14 may have an array of pixels configured to display images for a user. The pixels may be formed as part of a display panel that is bendable. This allows device 10 to be folded and unfolded about a bend axis. For example, a flexible (bendable) display in device 10 may be folded so that device 10 may be placed in a compact shape for storage and may be unfolded when it is desired to view images on the display.

Sensors 16 in input-output devices 24 may include force sensors (e.g., strain gauges, capacitive force sensors, resistive force sensors, etc.), audio sensors such as microphones, touch and/or proximity sensors such as capacitive sensors (e.g., a two-dimensional capacitive touch sensor integrated into display 14, a two-dimensional capacitive touch sensor overlapping display 14, and/or a touch sensor that forms a button, trackpad, or other input device not associated with a display), and other sensors. If desired, sensors 16 may include optical sensors such as optical sensors that emit and detect light, ultrasonic sensors, optical touch sensors, optical proximity sensors, and/or other touch sensors and/or proximity sensors, monochromatic and color ambient light sensors, image sensors, fingerprint sensors, temperature sensors, sensors for measuring three-dimensional non-contact gestures ("air gestures"), pressure sensors, sensors for detecting position, orientation, and/or motion (e.g., accelerometers, magnetic sensors such as compass sensors, gyroscopes, and/or inertial measurement units that contain some or all of these sensors), health sensors, radio-frequency sensors, depth sensors (e.g., structured light sensors and/or depth sensors based on stereo imaging devices that capture three-dimensional images), optical sensors such as self-mixing sensors and light detection and ranging (lidar) sensors that gather time-of-flight measurements, humidity sensors, moisture sensors, gaze tracking sensors, and/or other sensors. In some arrangements, device 10 may use sensors 16 and/or other input-output devices to gather user input. For example, buttons may be used to gather button press input, touch sensors overlapping displays can be used for gathering user touch screen input, touch pads may be used in gathering touch input, microphones may be used for gathering audio input, accelerometers may be used in monitoring when a finger contacts an input surface and may therefore be used to gather finger press input, etc.

If desired, electronic device 10 may include additional components (see, e.g., other devices 18 in input-output devices 24). The additional components may include haptic output devices, audio output devices such as speakers, light-emitting diodes for status indicators, light sources such as light-emitting diodes that illuminate portions of a housing and/or display structure, other optical output devices, and/or other circuitry for gathering input and/or providing output. Device 10 may also include a battery or other energy storage device, connector ports for supporting wired communication with ancillary equipment and for receiving wired power, and other circuitry.

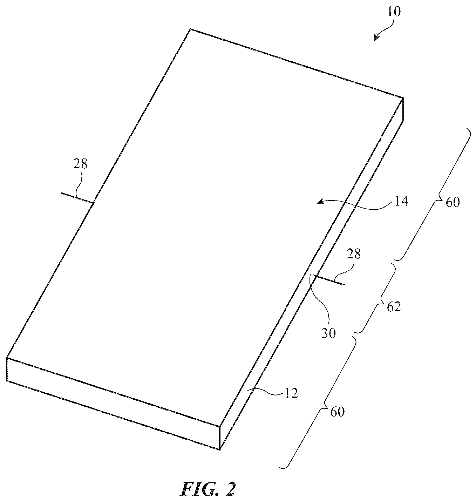

FIG. 2 is a perspective view of electronic device 10 in an illustrative configuration in which device 10 is a portable electronic device such as a cellular telephone or tablet computer. As shown in FIG. 2, device 10 may have a display such as display 14. Display 14 may cover some or all of the front face of device 10. Touch sensor circuitry such as two-dimensional capacitive touch sensor circuitry may be incorporated into display 14.

Display 14 may be mounted in housing 12. Housing 12 may form front and rear housing walls, sidewall structures, and/or internal supporting structures (e.g., a frame, an optional midplate member, etc.) for device 10. Glass structures, transparent polymer structures, and/or other transparent structures that cover display 14 and other portions of device 10 may provide structural support for device 10 and may sometimes be referred to as housing structures. For example, a transparent housing portion such as a glass or polymer housing structure that covers and protects a pixel array in display 14 may serve as a display cover layer for the pixel array while also serving as a housing wall on the front face of device 10. In configurations in which a display cover layer is formed from glass, the display cover layer may sometimes be referred to as a display cover glass or display cover glass layer. The portions of housing 12 on the sidewalls and rear wall of device 10 may be formed from glass or other transparent structures and/or opaque structures. Sidewalls and rear wall structures may be formed as extensions to the front portion of housing 12 (e.g., as integral portions of the display cover layer) and/or may include separate housing wall structures.

Device 10 may be a foldable electronic device that folds along one or more bend axes such as bend axis 28. In the example of FIG. 2, device 10 includes first and second portions 60 joined by bendable portion 62. Portions 60 of device 10 (e.g., portions 60 of display 14 and housing 12, sometimes referred to as the non-bending regions of device 10) may rotate relative to one another about axis 28. As one portion 60 rotates relative to another portion 60 (e.g., during folding and unfolding of device 10), bendable portion 62 of display 14 may bend and flex (e.g., while portions 60 remain flat).

Housing 12 may have flexible structures (e.g., bendable housing wall structures) and/or hinge structures such as hinge 30. Hinge 30 may have a hinge axis aligned with or offset relative to display bend axis 28, depending on the type of hinge used. Bend axis 28 may, for example, be the bend axis around which display 14 bends, whereas hinge 30 may bend about a hinge bend axis. In some arrangements such as teardrop hinge arrangements, the hinge bend axis of hinge 30 may be aligned with display bend axis 28 of display 14. In other arrangements such as constant length hinge arrangements (e.g., a roller hinge), the hinge bend axis may be offset from display bend axis 28. Device 10 may include one or more translation modules that facilitate translation of display 14 relative to housing 12 that may be required due to the offset between display bend axis 28 and the hinge bend axis.

Hinge 30 and/or flexible housing structures that overlap bend axis 28 may allow housing 12 to bend about the hinge bend axis. For example, portion 60 of housing 12 may be located on one side of hinge 30 and another portion 60 of housing 12 may be located on the opposing side of bend hinge 30. Portions 60 of housing 12 may be configured to rotate relative to one another about hinge 30. Hinge 30 may be a roller hinge including one or more rollers each having a longitudinal axis that extends parallel to bend axis 28. This is merely illustrative. If desired, hinge 30 may include other types of hinge structures.

As housing 12 is bent about hinge 30, the flexibility of display 14 allows display 14 to bend about axis 28. In an illustrative configuration, housing 12 and display 14 may bend by 180°. This allows display 14 to be folded back on itself (e.g., such that first and second portions 60 of display 14 face each other). The ability to place device 10 in a folded configuration in this way may help make device 10 compact so that device 10 can be stored efficiently. When it is desired to view images on display 14, device 10 may be unfolded about axis 28 to place device 10 in the unfolded (e.g., flat) configuration of FIG. 2. This allows display 14 to lie flat and allows a user to view flat images on display 14. The ability to fold display 14 onto itself allows device 10 to exhibit an inwardly folding behavior. Display 14 may be sufficiently flexible to allow device 10 to be folded outwardly and/or inwardly, if desired.

Device 10 of FIG. 2 has a rectangular outline (rectangular periphery) with four corners. As shown in FIG. 2, a first pair of parallel edges (e.g., the left and right edges of device 10 in the example of FIG. 2) may be longer than a second pair of parallel edges (e.g., the upper and lower edges of device 10 of FIG. 2) that are oriented at right angles to the first pair of parallel edges. In this type of configuration, housing 12 is elongated along a longitudinal axis that is perpendicular to bend axis 28. Housing 12 may have other shapes, if desired (e.g., shapes in which housing 12 has a longitudinal axis that extends parallel to bend axis 28). With an arrangement of the type shown in FIG. 2, the length of device 10 along its longitudinal axis may be reduced by folding device 10 about axis 28.

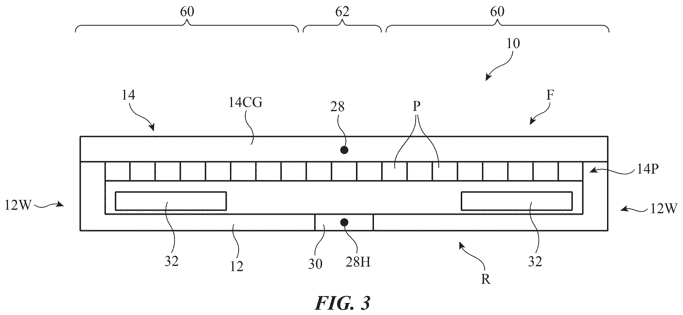

FIG. 3 is a cross-sectional side view of an illustrative foldable electronic device. Device 10 of FIG. 3 may bend about bend axis 28. Bend axis 28 may be aligned with display cover layer 14CG or other structures in device 10. For example, bend axis 28 may pass through a portion of display cover layer 14CG or may be located above or below layer 14CG.

Hinge 30 may bend about hinge bend axis 28H. In arrangements where hinge 30 is a teardrop hinge, hinge bend axis 28H of hinge 30 may be aligned with display bend axis 28 of display 14. In arrangements where hinge 30 is a constant length hinge such as a roller hinge, hinge bend axis 28H may be offset from display bend axis 28. Device 10 may include one or more translation modules that help slide display 14 relative to housing 12 during opening and closing of device 10 to accommodate the offset between display bend axis 28 and hinge bend axis 28H.

As shown in FIG. 3, display 14 includes an array of pixels P forming display panel 14P under an inwardly facing surface of display cover layer 14CG. Display panel 14P may be, for example, a flexible organic light-emitting diode display or a microLED display in which light-emitting pixels are formed on a flexible substrate layer (e.g., a flexible layer of polyimide or a sheet of other flexible polymer). Flexible support layer(s) for display 14 may also be formed from flexible glass, flexible metal, and/or other flexible structures.

Display cover layer 14CG may be formed from polymer, glass, crystalline materials such as sapphire, other materials, and/or combinations of these materials. To enhance flexibility, a portion of layer 14CG that overlaps bend axis 28 may be locally thinned (e.g., this portion may be thinned relative to portions of layer 14CG that do not overlap bend axis 28). The thickness of layer 14CG (e.g., the non-thinned portions of layer 14CG) may be 50-200 microns, 70-150 microns, 100-200 microns, 100-600 microns, at least 100 microns, at least 200 microns, less than 600 microns, less than 400 microns, less than 250 microns, less than 150 microns, less than 100 microns, at least 50 microns, or other suitable thickness.

In the example of FIG. 3, housing 12 has portions that form a rear housing wall on rear face R of device 10 and has portions forming sidewalls 12W of device 10. The rear housing wall of housing 12 may form a support layer for components in device 10. Housing 12 may also have one or more interior supporting layers (e.g., frame structures such as an optional midplate, etc.). These interior supporting layers and the rear housing wall may have first and second portions that are coupled to opposing sides of hinge 30 or may be sufficiently flexible to bend around bend axis 28.

Electrical components 32 may be mounted in the interior of device 10 (e.g., between display 14 and the rear of housing 12. Components 32 may include circuitry of the type shown in FIG. 1 (e.g., control circuitry 20, communications circuitry 22, input-output devices 24, batteries, etc.). Display 14 may be mounted on front face F of device 10. When device 10 is folded about axis 28, display cover layer 14CG, display panel 14P, and the other structures of device 10 that overlap bend axis 28 may flex and bend to accommodate folding.

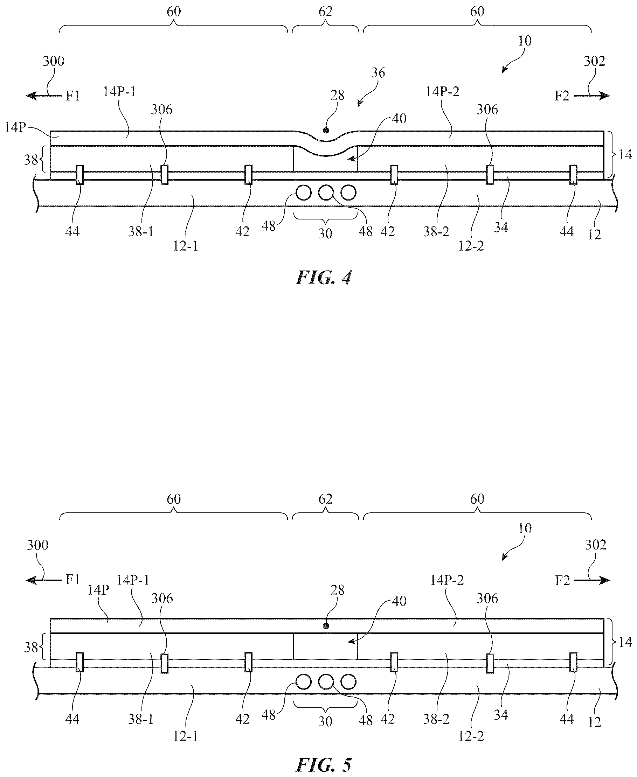

FIG. 4 is a side view of device 10 in a flat state (sometimes referred to as an open state or unfolded state). As shown in FIG. 4, device 10 may include foldable display 14 mounted to a housing such as foldable housing 12. Housing 12 may have first housing portion 12-1 and second housing portion 12-2. Hinge 30 may be located between housing portions 12-1 and 12-2 and may allow housing portions 12-1 and 12-2 to rotate relative to one another about hinge bend axis 28H. Housing portions 12-1 and 12-2 may form rear housing walls on the rear face R of device 10 (FIG. 3).

Display 14 may include a display panel such as display panel 14P mounted to a display plate such as display plate 38 (sometimes referred to as a support structure, a midplate, a backplate, etc.). Display plate 38 may include first portion 38-1 that supports a first portion 14P-1 of display panel 14P on one side of bend axis 28 and a second portion 38-2 that supports a second portion 14P-2 of display panel 14P on an opposing side of bend axis 28. Display plates 38-1 and 38-2 may rotate relative to one another about bend axis 28 as device 10 is opened and closed. Display plate 38-1 may overlap portion 12-1 of housing 12 and display plate 38-2 may overlap portion 12-2 of housing 12.

Display panel portion 14P-1 may be fixed relative to display plate 38-1, while display plate 38-1 may be movable relative to housing portion 12-1 (e.g., display plate 38-1 may be permitted to shear and slide relative to housing 12-1 during opening and closing of device 10). Similarly, display panel portion 14P-2 may be fixed relative to display plate 38-2, while display plate 38-2 may be movable relative to housing portion 12-2 (e.g., display plate 38-2 may be permitted to shear and slide relative to housing 12-2 during opening and closing of device 10). If desired, an optional shearing layer 34 may be interposed between housing 12 and display plate 38 to allow display 14 to slide relative to housing 12. Layer 34 may include one or more flexible polymers, coatings of lubricant, and/or other suitable slippery materials (e.g., polytetrafluoroethylene).

The ability of display 14 to move (e.g., slide) relative to housing 12 may permit housing 12 to use different types of hinge structures such as a roller hinge. In particular, hinge 30 may be a roller hinge having one or more parallel rollers such as rollers 48. Rollers 48 may have longitudinal axes that extend parallel to bend axis 28. Hinges of this type (sometimes referred to as constant-length hinges) may span a distance between housing portions 12-1 and 12-2 that remains constant as device 10 is folded and unfolded. This is merely illustrative, however. If desired, hinge 30 may be any other suitable type of hinge (e.g., a four-bar linkage, a teardrop hinge, a flexible housing member, etc.). In some hinge arrangements (such as a teardrop hinge), translation of display 14 relative to housing 12 may be used to absorb tolerances (e.g., during manufacturing or during operation of device 10 by a user over time). Arrangements in which display 14 slides relative to housing 12 during opening and closing of device 10 are sometimes described herein as an illustrative example.

To drive display translation relative to housing 12, device 10 may include one or more translation assemblies such as translation assembly 306. Translation assembly 306 may include springs, elastic members, movable straps, pullies, hydraulics, motors, rack-and-gear mechanisms, pin-and-slot mechanisms, sliders, linkages (e.g., levers, crank levers, four-bar linkages such as Watts linkages, etc.) and/or other suitable structures that apply forces to display 14 to slide display 14 relative to housing 12.

Care must be taken to ensure that wrinkles and creases are not present in display 14 when device 10 is in the unfolded state of FIG. 4. In the absence of applied tension, display 14 may have a tendency to maintain a bend such as crease 36 in bend region 62 even when device 10 is unfolded.

To avoid creases such as crease 36 when device 10 is unfolded, device 10 may include one or more tensioning assemblies such as tension assemblies 44. Tension assemblies 44 may be coupled between display plate 38 and housing 12. In particular, one or more tension assemblies 44 may be located between display plate portion 38-1 and housing portion 12-1 and may apply a force F1 to display plate 38-1 to move display panel portion 14P-1 in direction 300 relative to housing portion 12-1. One or more tension assemblies 44 may be located between display plate portion 38-2 and housing portion 12-2 and may apply a force F2 to display plate 38-2 to move display panel portion 14P-2 in direction 302 relative to housing portion 12-2. Forces F1 and F2 may be different or may be equal to one another.

Tension assemblies 44 may serve to remove wrinkles and prevent buckling in display 14 when device 10 is unfolded and may also serve to absorb tolerances during manufacturing, after a drop event or other impact event, and/or as device 10 is used over time. In particular, a drop event or other impact may result in small changes in distance between housing portions 12-1 and 12-2. Tension assemblies 44 may be used to pull display 14 flat and thereby avoid wrinkles in display 14 that might otherwise arise from drop events. When tension such as forces F1 and F2 are applied to pull display 14 flat in this way, crease 36 may be avoided, as shown in FIG. 5.

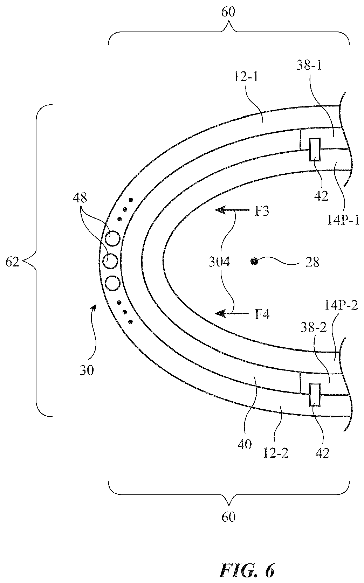

If desired, device 10 may also include one or more compression assemblies such as compression assemblies 42. Compression assemblies 42 may be used to help push display 14 up against hinge 30 when device 10 is folded to prevent tenting and lift-off of the display relative to the hinge. Tenting occurs when the display 14 separates away from hinge 30. As shown in FIG. 6, for example, one or more compression assemblies 42 may be located between display plate portion 38-1 and housing portion 12-1 and may apply a force F3 to display plate 38-1 to move display panel portion 14P-1 in direction 304 relative to housing portion 12-1. One or more compression assemblies 42 may be located between display plate portion 38-2 and housing portion 12-2 and may apply a force F4 to display plate 38-2 to move display panel portion 14P-2 in direction 304 relative to housing portion 12-2. Forces F3 and F4 may be different or may be equal to one another.

If desired, tension assemblies 44 and compression assemblies 42 may be active across different ranges of motion of device 10. For example, when device 10 is in the flat state of FIG. 5 (e.g., when housing portions 12-1 and 12-2 are separated by an angle of 180°), tension assemblies 44 may be actively applying tension while compression assemblies 42 may be inactive or may be applying a compressive force that is less than the tension force applied by tension assemblies 44. As device 10 begins folding and the angle between housing portions 12-1 and 12-2 is reduced from 180° (e.g., to 179°, 178°, 175°, or other suitable threshold angle), tensioning module 44 may become inactive or may otherwise be overcome by the compressive force applied by compression assemblies 42. Compression assemblies 42 may actively apply compression to display 14 across any suitable range of angles (e.g., when the angle between housing portions 12-1 and 12-2 is between 0° and 179°, between 0° and 178°, between 0° and 177°, etc.). Tension assemblies 44 may apply tension to display 14 across a smaller range of angles (e.g., when the angle between housing portions 12-1 and 12-2 is between 179° and 180°, between 178° and 180°, between 177° and 180°, etc.), if desired.

Tension assemblies 44 and compression assemblies 42 may include springs, elastic members, movable straps, pullies, hydraulics, motors, rack-and-gear mechanisms, pin-and-slot mechanisms, sliders, linkages (e.g., levers, crank levers, four-bar linkages such as Watts linkages, etc.) and/or other suitable structures that apply forces to display 14 such as compression forces and tension forces. In some arrangements, tension assembly 44 may include a spring that is loaded by a slider element in hinge 30 (e.g., a slider element in a teardrop hinge that slides away from bend axis 28 as device 10 unfolds and thereby applies a load to the spring, which in turn applies tension to display 14). This is merely illustrative. If desired, hinge 30 may be a roller hinge and other tensioning structures may be used to form tension assemblies 44.

In some arrangements, tension and/or compression may also or instead be applied to display 14 using translation assemblies 306 (e.g., translation assemblies 306 may be used to form compression assemblies 42 and/or tension assemblies 44, if desired).

Tension assemblies 44, compression assemblies 42, and/or translation assemblies 306 may be mechanically driven by one or more linkages or may be actively controlled using one or more actuators (e.g., linear actuators). Actuators may drive display motion and/or may apply tension or compression to display 14 in response to user input (e.g., touch input to display 14, button press input, voice input, gesture input, eye gaze input, etc.), in response to sensor data (e.g., motion sensor data, ambient light sensor data, depth sensor data, etc.), and/or in response to other input. For example, actuators may actively slide one or both of display panel portions 14P-1 and 14P-2 to expose a camera mounted to housing 12 (e.g., in response to a camera application being launched on device 10).

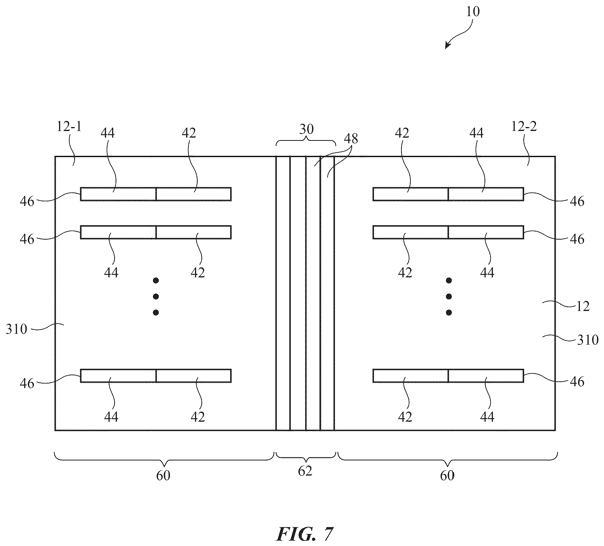

FIG. 7 is a top view of a portion of device 10 showing illustrative locations for tension assemblies 44 and compression assemblies 42. In the example of FIG. 7, tension assemblies 44 and compression assemblies 42 are mounted on both portion 12-1 and portion 12-2 of housing 12 (e.g., between housing 12 and display plate 38, as discussed in connection with FIGS. 4, 5, and 6). This is merely illustrative. If desired, one portion of display 14 may be fixed relative to housing 12 and another portion of display 14 may be movable relative to housing 12, in which case tension assemblies 44 and compression assemblies 42 may only be located on portion 12-1 or portion 12-2 of housing 12. For example, if display panel portion 14P-1 and display plate portion 38-1 are fixed relative to housing portion 12-1, then tension assemblies 44 and compression assemblies 42 may only be configured to slide display panel portion 14P-2 and display plate portion 38-2 relative to housing portion 12-2. Arrangements in which both sides of display 14 are configured to slide relative to housing 12 are sometimes described herein as an illustrative example.

Tension assemblies 44 and compression assemblies 42 may be configured to slide both sides of display 14 symmetrically with respect to one another (e.g., both sides of display 14 may move by the same amount at the same time), or the movement of the two display sides may be asymmetric, if desired (e.g., one side of display 14 may move at a different time and/or by a different amount than the other side of display 14). If tension assemblies 44 and/or compression assemblies 42 on opposing sides of hinge 30 apply equal loads to display panel portion 14P-1 and display panel portion 14P-2, the motion of display panel portion 14P-1 and display panel portion 14P-2 will be symmetric. On the other hand, if tension assemblies 44 and/or compression assemblies 42 on opposing sides of hinge 30 apply unequal loads to display panel portion 14P-1 and display panel portion 14P-2, the motion of display panel portion 14P-1 and display panel portion 14P-2 will be asymmetric (e.g., display panel portion 14P-1 may slide at a different time and/or by a different amount compared to display panel portion 14P-2).

Tension assemblies 44 and compression assemblies 42 may be assembled into a single module (e.g., tension and compression module 46), or tension assemblies 44 may be separate modules from compression assemblies 42. If desired, each portion 12-1 and 12-2 of housing 12 may have multiple tension assemblies 44 and compression assemblies 42 (e.g., multiple tension and compression modules 46). This may help ensure that tension and compression is applied evenly across display 14 and may also serve to absorb tolerances after a drop event. In some arrangements, tension assemblies 44 and/or compression assemblies 42 may be configured to rotate display 14 relative to housing 12 (e.g., about an axis that is normal to display 14) to absorb tolerances when necessary.

If desired, tension assemblies 44 and compression assemblies 42 may be mounted within recesses, slots, or grooves in housing 12 (e.g., in inner surface 310 of housing 12 facing display 14). In other arrangements, tension assemblies 44 and compression assemblies 42 may be mounted to a non-recessed portion of inner surface 310 housing 12. If desired, compression assemblies 42 may be located closer to hinge 30 than tension assemblies 44 to ensure that compression forces push region 62 of display 14 into hinge 30 rather than creating wrinkles in other regions of display 14 such as regions 60.

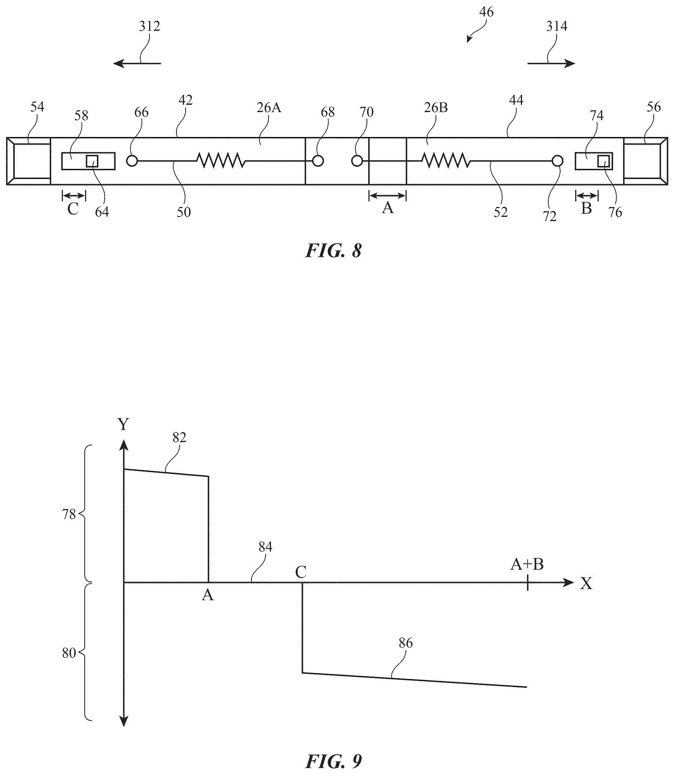

FIG. 8 is a top view of an illustrative tension and compression module 46. Tension and compression module 46 may include tension assembly 44 mounted in groove 56 and compression assembly 42 mounted in groove 54. Grooves 56 and 54 may be grooves in housing 12 (e.g., grooves in inner surface 310 of housing 12 of FIG. 7) or may be grooves in a separate frame member or support structure that is fixed to housing 12 (e.g., fixed to inner surface 310 of housing 12).

Each assembly may include a slider that slides within the groove. Compression assembly 42 may include slider 26A that slides within groove 54, and tension assembly 44 may include slider 26B that slides within groove 56. Slider 26A may include slot 58 and slider 26B may include slot 74. Pin 64 may be configured to slide within slot 58 and pin 76 may be configured to slide within slot 74. Pins 64 and 76 may be fixed to display 14 (e.g., to display plate portion 38-1 and or display plate portion 38-2, depending on which side of hinge 30 module 46 is located) while being moveable relative to housing 12.

Each assembly may include a spring, elastomer, or other elastic member to drive display motion. Compression assembly 42 may include spring 50 coupled between post 66 and post 68, whereas tension assembly 44 may include spring 52 coupled between post 70 and post 72. Post 66 may be fixed relative to slider 26A and post 68 may be fixed relative to housing 12. Post 72 may be fixed relative to slider 26A, and post 70 may be fixed relative to housing 12. Gap A sets the distance that display 14 moves while under tension from tension assembly 44, whereas gap C sets the distance that display 14 moves before compression assembly 42 begins applying compression to display 14. Gap A plus gap B sets the hard stop position where display 14 is no longer moving relative to housing 12.

FIG. 9 is a graph showing how the compression and tension forces applied to display 14 by module 46 (e.g., module 46 of FIG 8 or any other suitable tension and compression module) may change as device 10 moves from an open position (e.g., the flat position of FIG. 5 in which housing portions 12-1 and 12-2 are separated by an angle of 180°) to a closed position (e.g., the folded position of FIG. 6 in which housing portions 12-1 and 12-2 are separated by an angle of 0°). The Y-axis of FIG. 9 represents force (e.g., with the +Y axis in region 78 corresponding to tension and the -Y axis in region 80 corresponding to compression). The X-axis of FIG. 9 represents stroke (e.g., the phase of movement of device 10 as it moves from an open flat position to a folded closed position).

As shown by segment 82 in the curve of FIG. 9, pre-loaded tension module 44 of FIG. 8 may apply tension to display 14 to pull display 14 flat and remove any creases while device 10 is in the flat state. As user begins to fold device 10, slider 26B may slide within groove 56 in direction 312 across distance A until it reaches the end of groove 56. When slider 26B hits the end of groove 56, tension assembly 44 may become inactive and slider 26A may begin to slide in groove 54 in direction 312. If desired, there may be some range of motion (dictated by the size of gap C) where neither tension nor compression is applied to display 14, as indicated by segment 84 in the curve of FIG. 9. As slider 26A moves in direction 312 and starts moving pin 64 in direction 312, compression assembly 42 may become active and may start applying a compressive force to display 14 that pushes display 14 into bend region 62 (e.g., into hinge 30), as indicated by segment 86 in the curve of FIG. 9. Gap A plus gap B sets a hard stop at which point display 14 is fully folded and motion stops. During opening, a reverse process occurs as sliders 26A and 26B move in direction 314.

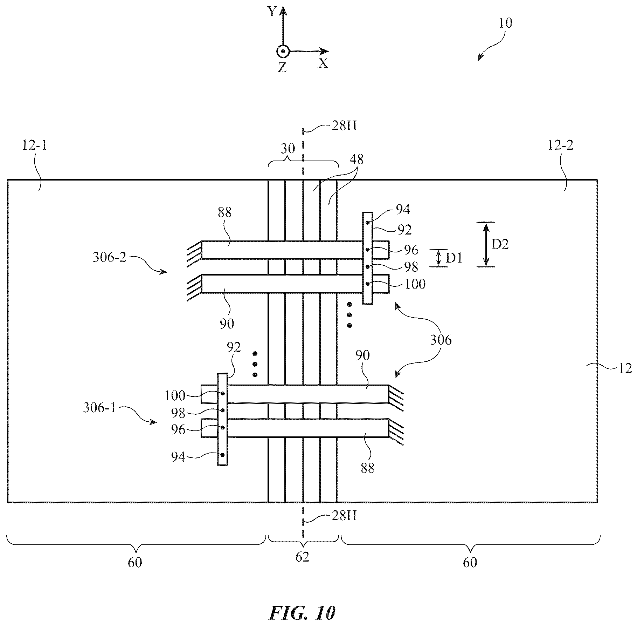

FIG. 10 is a top view of a portion of device 10 showing an illustrative translation assembly such as translation assemblies 306 that may be used to drive movement of display 14 (e.g., display panel 14P and display plate 38 of FIGS. 1-6) relative to housing 12. In this example, each translation assembly 306 includes a pair of straps such as strap 88 and strap 90 extending across hinge 30. Straps 88 and 90 may each have a first end coupled to housing 12 and display 14 through a linkage such as lever 92 on one side of hinge 30 and an opposing second end anchored to housing 12 on the opposing side of hinge 30. For example, a first end of straps 88 and 90 of module 306-1 may be coupled to housing portion 12-1 and display panel portion 14P-1 through lever 92, and a second opposing end of straps 88 and 90 may be anchored to housing portion 12-2. A first end of straps 88 and 90 of module 306-2 may be coupled to housing portion 12-2 and display panel portion 14P-2 through lever 92, and a second opposing end of straps 88 and 90 may be anchored to housing portion 12-1. Strap 88 may be coupled to lever 92 at pivot point 96, and strap 90 may be coupled to lever 92 at pivot point 100. Lever 92 may be coupled to housing 12 at pivot point 98 and may be coupled to display 14 (e.g., display plate 38) at pivot point 94.

Straps 88 and 90 may be located at different offsets from axis 28H of rotation of hinge 30 (e.g., at different heights relative to the Z-axis of FIG. 10). For example, strap 88 may be above axis 28H of rotation of hinge 30 and may sometimes be referred to as inner strap 88. Strap 90 may below axis 28H of rotation of hinge 30 and may sometimes be referred to as outer strap 90. This Z-height offset relative to axis 28H causes straps 88 and 90 to have different effects on the motion of display 14, depending on whether a user is opening or closing device 10. In particular, as housing 12 moves from the closed position of FIG. 6 to the open position of FIG. 5, the length of inner strap 88 that passes through hinge 30 may become longer, causing the moving end of inner strap 88 to move inwards towards hinge 30. At the same time, the length of outer strap 90 that passes through hinge 30 may become shorter as the device opens, causing the moving end of outer strap 90 to move outwardly away from hinge 30. When housing 12 moves from the open position of FIG. 5 to the closed position of FIG. 6, the length of inner strap 88 that passes through hinge 30 may become shorter, causing the moving end of inner strap 88 to move outwardly away from hinge 30. At the same time, the length of outer strap 90 that passes through hinge 30 may become longer as the device closes, causing the moving end of outer strap 90 to move inwardly towards hinge 30. Because straps 88 and 90 are coupled between housing 12 and display 14 using a linkage such as lever 92, this motion of straps 88 and 90 may be used to drive the motion of display 14 during opening and closing of device 10. The use of a lever is merely illustrative. If desired, lever 92 may be replaced by any other suitable linkage such as a four-bar linkage (e.g., a Watts linkage).

The motion of straps 88 and 90 (and therefore the motion of display 14) is dependent on the amount of offset that straps 88 and 90 have from the axis of rotation of hinge 30. If desired, the motion of display 14 may be amplified by placing pivot point 94 (where display 14 is pinned to lever 92) at a further distance away from pivot point 98 (where lever 92 is pinned to housing 12) than pivot points 96 and 100. In particular, pivot points 96 and 100 (where straps 88 and 90 are coupled to lever 92, respectively) may each be located a distance D1 from pivot point 98, whereas pivot point 94 may be located at distance D2 from pivot point 98 (e.g., a distance greater than D1). This amplifies the motion of display 14 that results from the movement of straps 88 and 90.

In the example of FIG. 10, module 306-1 is used to drive the motion of display panel portion 14P-1 on housing portion 12-1, and module 306-2 is used to drive the motion of display panel portion 14P-2 on housing portion 12-2. This is merely illustrative. If desired, the same pair of straps may be used to drive the motion of both display panel portion 14P-1 and display panel portion 14P-2. With this type of configuration, both ends of straps 88 and 90 would be coupled between housing 12 and display 14 using a respective lever (e.g., lever 92 may be used on both ends of straps 88 and 90 instead of anchoring one end of straps 88 and 90 to housing 12). The center of each strap may be anchored to housing 12 (e.g., along hinge 30).

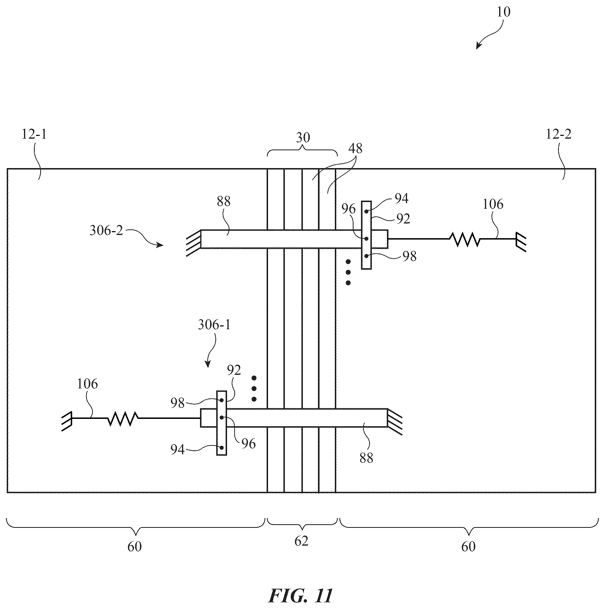

In another illustrative configuration, the two straps of each module 306 may be replaced by a single strap that is used to drive the motion of display 14 in both directions. This type of arrangement may result in some backlash. To avoid backlash in a single-strap configuration, a return spring may be used. This type of arrangement is illustrated in FIG. 11.

As shown in FIG. 11, module 306-1 may include strap 88 having a first end anchored to housing portion 12-2 and a second opposing end coupled to lever 92 at pivot point 96. Lever 92 of module 306-1 may be coupled to housing portion 12-1 at pivot point 98 and may be coupled to display panel portion 14P-1 at pivot point 94. Module 306-2 may include strap 88 having a first end anchored to housing portion 12-1 and a second opposing end coupled to lever 92 at pivot point 96. Lever 92 of module 306-2 may be coupled to housing portion 12-2 at pivot point 98 and may be coupled to display panel portion 14P-2 at pivot point 94. As in the example of FIG. 10, the distance between pivot point 94 and pivot point 98 may be greater than the distance between pivot point 96 and pivot point 98. This helps amplify the display motion that is caused by strap 88.

The non-anchored end of strap 88 of each module 306 may be coupled to a spring such as spring 106. Spring 106 may have a first end coupled to strap 88 and a second end anchored to housing 12. Spring 106 may keep strap 88 in tension to prevent buckling of strap 88.

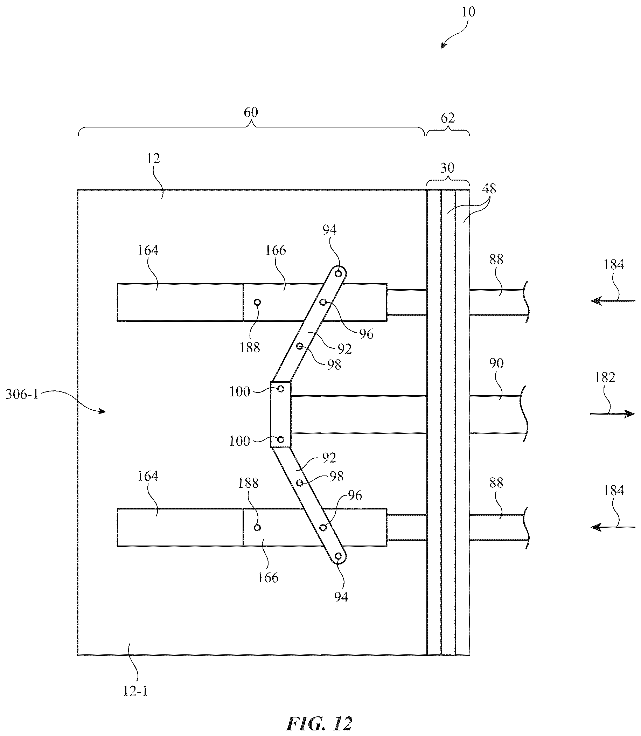

FIG. 12 is a rear view of a portion of device 10 showing another illustrative configuration for using straps and a lever to drive display motion relative to housing 12. Similar to the example of FIG. 10, each module 306 may include inner and outer straps coupled to a lever and located at different offsets relative to the axis of rotation of hinge 30. In the example of FIG. 12, module 306-1 includes first and second inner straps 88, outer strap 90, and first and second levers 92. A first lever 92 may be coupled to one of inner straps 88 and outer strap 90, and a second lever 92 may be coupled to the other inner strap 88 and outer strap 90. One end of each strap may be anchored to housing portion 12-2 (not shown in FIG. 12), and the opposing end of each strap may be coupled to one of levers 92. Inner straps 88 may each be coupled to a slider such as slider 166 that slides within a slot such as slot 164. Each slider 166 may be coupled to display panel portion 14P-1 (e.g., to display plate 38-1, for example) via screw 188. As in the example of FIG. 10, the distance between pivot point 94 and pivot point 98 may be greater than the distance between pivot point 96 and pivot point 98. Additionally, pivot point 94 and pivot point 96 may be located at different offsets with respect to pivot point 98 (as opposed to being located in-line). This helps amplify the display motion that is caused by strap 88.

As device 10 moves from the open position of FIG. 12 to the closed position of FIG. 6, inner straps 88, sliders 166, and display panel portion 14P-1 may move in direction 184, while outer strap 90 may move in direction 182 to pull on levers 92, causing levers 92 to rotate about pivot points 98. During opening, a reverse process occurs, as inner straps 88 actively pull display panel 14P-1 in direction 182 and outer strap 90 is passive. Module 306-2 (not shown) may be a mirror image of module 306-1 on housing portion 12-2 to drive motion of display panel portion 14P-2.

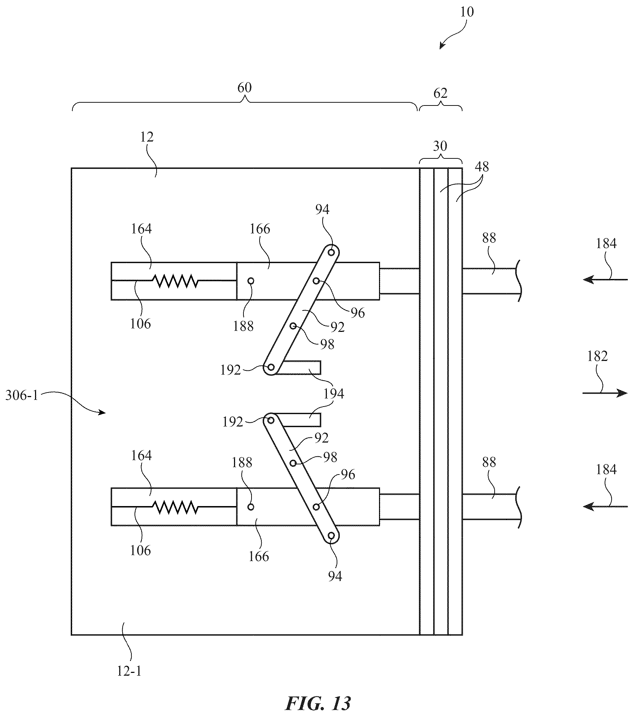

FIG. 13 is a rear view of a portion of device 10 showing another illustrative configuration for using straps and a lever to drive display motion relative to housing 12. Similar to the example of FIG. 11, each module 306 may include one or more straps coupled to a lever and a return spring. In the example of FIG. 13, module 306-1 includes first and second straps 88 (e.g., located at the same offset relative to the axis of rotation of hinge 30) respectively coupled to first and second levers 92 and first and second return springs 106. A first lever 92 may be coupled to a first strap 88, and a second lever 92 may be coupled to a second strap 88. One end of each strap 88 may be anchored to housing portion 12-2 (not shown in FIG. 13), and the opposing end of each strap 88 may be coupled to one of levers 92. Straps 88 may each be coupled to a slider such as slider 166 that slides within a slot such as slot 164. Each slider 166 may be coupled to display panel portion 14P-1 (e.g., to display plate 38-1, for example) via screw 188. As in the example of FIG. 11, the distance between pivot point 94 and pivot point 98 may be greater than the distance between pivot point 96 and pivot point 98. Additionally, pivot point 94 and pivot point 96 may be located at different offsets with respect to pivot point 98 (as opposed to being located in-line). This helps amplify the display motion that is caused by strap 88.

In some arrangements, levers 92 may be coupled to an outer strap 90 (not shown), similar to the examples of FIGS. 11 and 12. With this type of arrangement, levers 92 may each have one end coupled to outer strap 90 at pivot point 192 and coupled to a display slider that slides within slot 194 as device 10 opens and closes. In other arrangements, outer strap 90 may be omitted, in which case slots 194 and pivot points 192 may also be omitted.

As device 10 moves from the open position of FIG. 13 to the closed position of FIG. 6, straps 88, sliders 166, and display panel portion 14P-1 may move in direction 184, while springs 106 pull levers 92 and cause levers 92 to rotate about pivot points 98. Springs 106 may help prevent straps 88 from buckling during closing. During opening, a reverse process occurs, as straps 88 actively pull display panel 14P-1 in direction 182. Module 306-2 (not shown) may be a mirror image of module 306-1 on housing portion 12-2 to drive motion of display panel portion 14P-2.

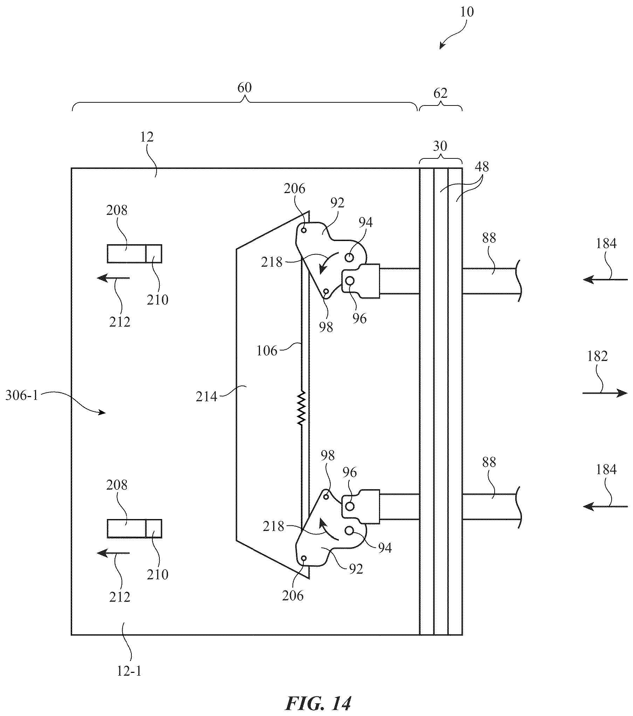

FIG. 14 is a rear view of a portion of device 10 showing another illustrative configuration for using straps and a lever to drive display motion relative to housing 12. Similar to the example of FIG. 11, each module 306 may include one or more straps coupled to a lever and a return spring. In the example of FIG. 14, levers 92 are crank levers and spring 106 is coupled between first and second crank levers 92 at respective pivot points 206. First and second straps 88 (e.g., located at the same offset relative to the axis of rotation of hinge 30) may have first ends respectively be coupled to first and second crank levers 92 at pivot points 96, and may have second ends respectively anchored to housing portion 12-2 (not shown in FIG. 14). Crank levers 92 may be coupled to display 14 at pivot points 94 and may be coupled to housing 12 at pivot points 98.

As device 10 moves from the open position of FIG. 14 to the closed position of FIG. 6, straps 88 and display panel portion 14P-1 move in direction 184, and crank levers 92 rotate inwardly in directions 218 about pivot points 98. This inward movement of crank levers 92 pushes spring 106 in direction 184 within slot 214, and the load of spring 106 decreases as the distance between attachment points 206 decreases. At the same time, the leverage of spring 106 increases so that constant tension on straps 88 is maintained. The spring loading direction is such that the moment arm on crank lever 92 increases as the length of spring 106 decreases, resulting in constant (or approximately constant) torque on crank lever 92. During opening, a reverse process occurs, as straps 88 actively pull display panel 14P-1 in direction 182. Module 306-2 (not shown) may be a mirror image of module 306-1 on housing portion 12-2 to drive motion of display panel portion 14P-2.

If desired, each module 306 may include one or more additional attachment points between display 14 and housing 12 to constrain motion of display 14 in the desired range. For example, screws 210 may be attached to display 14 (e.g., to display plate 38-1) and may be configured to slide within respective slots 208 in housing portion 12-1 during opening and closing. For example, screws 210 may slide in slots 208 in direction 212 as display panel 14P-1 moves in direction 212 during opening.

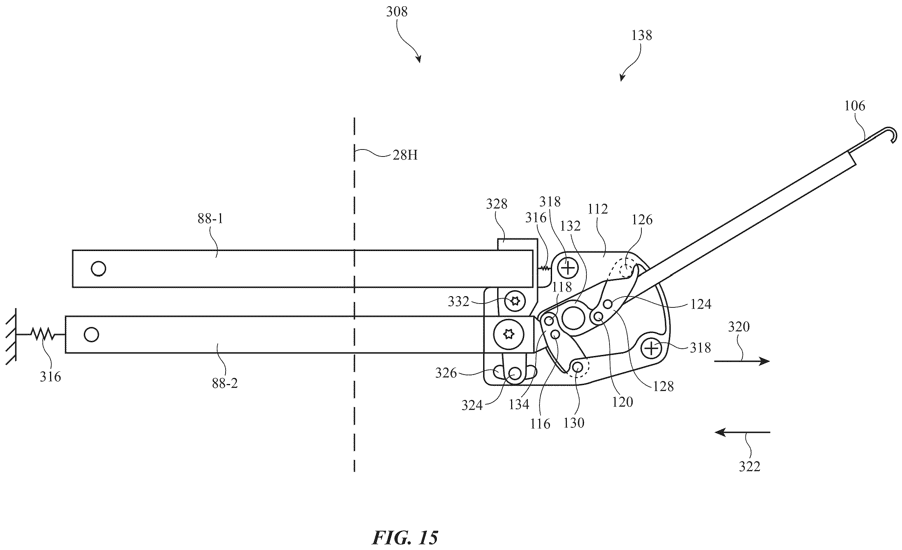

If desired, modules 306 of FIGS. 10 and 11 may use a four-bar linkage mechanism in lieu of lever 92 to drive display motion relative to housing 12. This type of arrangement is illustrated in FIG. 15. FIG. 15 shows an illustrative assembly 308 that may be used in place of lever 92 to form translation assembly 306 and/or compression assembly 42.

As shown in FIG. 15, assembly 308 may include Watts linkage 138. Watts linkage 138 may be a four-bar linkage that creates a linear motion that is applied to display 14 (e.g., to display panel portion 14P-1 and/or display panel portion 14P-2, as discussed in connection with FIG. 6). In contrast to lever 92, which travels through an arc, Watts linkage 138 results in a linear motion, eliminating the need for sliders that create sliding friction while also reducing uncertainty about the current location of display 14 relative to housing 12.

Watts linkage 138 may include frame member 112, a first crank 134 that rotates relative to frame member 112 about pivot point 130, a second crank 128 that rotates relative to frame member 112 about pivot point 126, and link 132 coupled between cranks 134 and 128 at respective pivot points 118 and 120. Link 132 may be coupled to display 14 (e.g., to display plate 38-2). Frame member 112 may be attached to housing 12 (e.g., to housing portion 12-2) using one or more screws such as screws 318. First crank 134 may be coupled to strap 88-2 at pivot point 116, and second crank 128 may be coupled to a return spring such as spring 106 at pivot point 124. Strap 88-2 may have a first end coupled to crank 134 at pivot point 116 and an opposing second end anchored to the opposing housing portion 12-1. Spring 106 may be used to apply a force to crank lever 128 to maintain tension in strap 88-2 and prevent strap buckling.

In this example, Watts linkage 138 may be used to drive motion of display panel portion 14P-2. A mirror image of Watts linkage 138 of FIG. 15 may be formed on the opposing housing portion 12-1 to drive motion of display panel portion 14P-1. If desired, the strap of assembly 308 on the opposing housing portion 12-1 such as strap 88-1 may be anchored to Watts linkage 138 of FIG. 15 (and strap 88-2 may be anchored to the Watts linkage mechanism 138 on housing portion 12-1). If desired, linkage 138 may include one or more stop structures such as an adjustment screw that limits travel of crank lever 128 and/or crank lever 134.

In some arrangements, assembly 308 may be used for display translation only (e.g., to form translation assembly 306) and may include straps 88-1 and 88-2 that are anchored directly to housing 12. In other arrangements, assembly 308 may be used to apply compression to display 14 and may therefore be used to form compression assembly 42. With this type of arrangement, assembly 308 may include straps 88-1 and 88-2 that are coupled to housing 12 through respective springs 316. As shown in FIG. 15, for example, strap 88-1 may be coupled to lever 328 on assembly 308 on housing portion 12-2, and lever 328 may be coupled to housing portion 12-2 via spring 316. Strap 88-2 may be coupled to a similar lever on the assembly 308 that is coupled to housing portion 12-1 (not shown) via a similar spring 316. Lever 328 may be coupled to a screw 324 that moves within slot 326 of frame 112 as lever 328 rotates about pivot point 332. Spring 316 of assembly 308 may bias lever 328 away from hinge axis 28H, thereby applying tension to the anchored end of strap 88-1. Lever 328 may not be configured to move significantly but may be used to apply constant strap tension. Motion of lever 328 that does occur may be due to translation motion error or tolerances. If the spring-lever system is active in order to provide display compression, screw 324 may be left loose. Alternatively, if the spring-lever system is used to automatically adjust the strap during assembly, screw 324 can be tightened to lock the adjustment. As device 10 moves to a folded closed position, the tension in strap 88-1 tends to pull lever 328 inward towards hinge 30, which in turn pulls each side of display 14 inward and places the bend region of the display in compression.

As device 10 moves from the open position of FIG. 15 to the closed position of FIG. 6, strap 88-2 may move in direction 320, and crank levers 134 and 128 may rotate about respective pivot points 130 and 126, thereby causing linear motion of link 132 and display panel portion 14P-2 in direction 320. During opening, a reverse process occurs, as strap 88-2 moves in direction 322 and crank levers 134 and 128 rotate in the opposite direction about respective pivot points 130 and 126, thereby causing linear motion of link 132 and display panel portion 14P-2 in direction 322. When operated in conjunction with a mirror image assembly 308 on the opposing housing portion 12-1, assembly 308 may pull the two halves of display 14 towards each other (e.g., at all angles). In arrangements where straps 88-1 and 88-2 are coupled to levers 328 via respective springs 316, assembly 308 may also be used to apply compression to display 14 in bend region 62 and thereby prevent tenting or lift-off of display 14 relative to hinge 30.

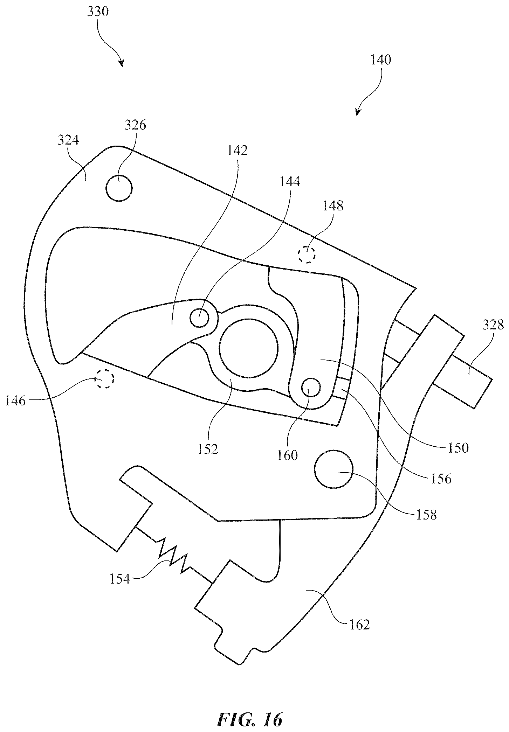

FIG. 16 is a top view of an illustrative assembly 330 that may be used to form tension assembly 44 and/or translation assembly 306. If desired, assembly 330 may be used in conjunction with assembly 308 of FIG. 15. As shown in FIG. 16, assembly 330 may include Watts linkage 140. Watts linkage 140 may be a four-bar linkage that includes frame member 324, a first crank 142 that rotates relative to frame member 324 about pivot point 146, a second crank 150 that rotates relative to frame 324 about pivot point 148, and link 152 coupled between cranks 142 and 150 at respective pivot points 144 and 160. Link 152 may be coupled to display 14 (e.g., to display plate 38-1 or display plate 38-2). Frame member 324 may be attached to housing 12 (e.g., to housing portion 12-1 or housing portion 12-2) using one or more screws such as screws 326.

A lever such as lever 162 may be coupled to frame 324 at pivot point 158 and may have a cam such as cam 156 that applies a force onto center link 152 if in contact. A stop structure such as screw 328 may be coupled to lever 162 and may set the angle at which cam 156 contacts center link 152. When screw 328 contacts frame 324, no load is applied to center link 152 (and thus no load is applied to display 14). Spring 154 may be coupled between lever 162 and frame 324 and may be used to apply a force onto lever 162. Spring 154 may be pre-loaded while screw 328 is in contact with frame 324.

When housing portions 12-1 and 12-2 are separated by an angle that is less than some threshold angle (e.g., less than 165°, less than 179°, less than 178°, less than 170°, or any other suitable threshold angle), adjustment screw 328 carries the load of spring 154 with no load transferred to link 152 (and, therefore, with no load transferred to display 14). When housing portions 12-1 and 12-2 are separated by angles greater than the threshold angle, link 152 contacts cam 156 and rotates lever 162 about pivot point 158, thereby compressing pre-loaded spring 154 and transferring load from screw 328 to link 152 and in turn to display 14 (e.g., to display panel portion 14P-1 or 14P-2). When operated in conjunction with a mirror image assembly 330 on the opposing housing portion, the resulting force of assemblies 330 may be greater than the compression force applied by assembles 308 of FIG. 15, such that the two display halves 14P-1 and 14P-2 are pushed apart from one another when housing 12 is in the flat state. This tension helps remove creases in display 14, as discussed in connection with FIGS. 4 and 5.

As discussed in connection with FIG. 7, multiple tension assemblies 44 such as assemblies 330 of FIG. 16 and multiple compression assemblies 42 such as assemblies 308 of FIG. 15 may be mounted on each side of hinge 30 (e.g., one at each corner of housing portion 12-1 and housing portion 12-2, for example). In some arrangements, assembly 330 of FIG. 16 and assembly 320 of FIG. 15 may be combined into a single assembly that performs both tension and compression.

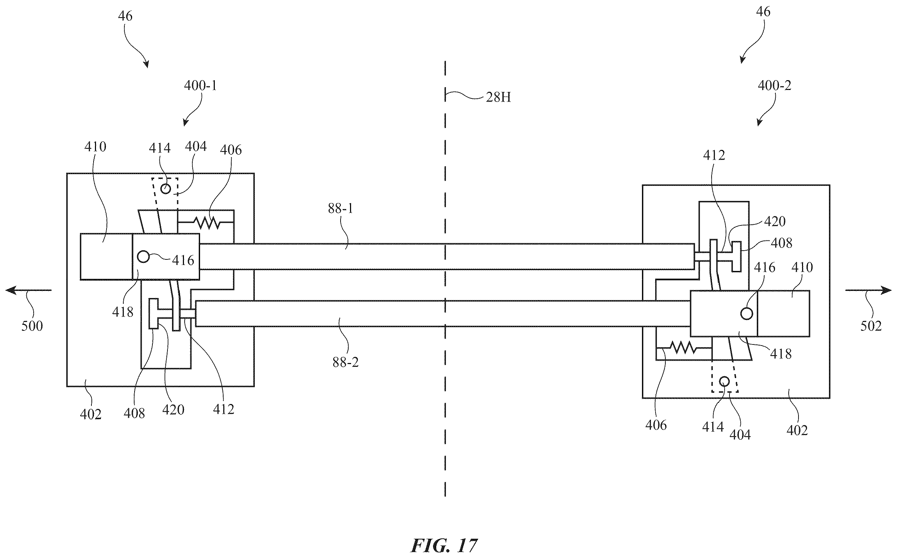

FIG. 17 is a top view of illustrative tension and compression modules 46 that may be used to apply both tension and compression to display 14. Tension and compression modules 46 may include assembly 400-1 mounted to housing portion 12-1 and assembly 400-2 mounted to housing portion 12-2. Straps 88-1 and 88-2 may be coupled between assemblies 400-1 and 400-2 and may extend across hinge axis 28H.

Each assembly 400-1 and 400-2 may include a frame such as frame 402. Frame 402 of assembly 400-1 may be attached to housing portion 12-1 using one or more screws or other attachment structures. Frame 402 of assembly 400-2 may be attached to housing portion 12-2 using one or more screws or other attachment structures. Each assembly 400-1 and 400-2 may include a lever such as lever 404. Lever 404 may rotate about pivot point 414. Each lever 404 may be biased away from hinge axis 28H using an elastic member such as spring 406.

Lever 404 may have a surface that contacts shuttle 418 when device 10 is in a fully open or partially open state (e.g., when housing portions 12-1 and 12-2 are separated by an angle ranging from 165° to 180° or other suitable range of angles). Shuttle 418 may be coupled to display 14. For example, shuttle 418 of assembly 400-1 may be coupled to display panel portion 14P-1 via screw 416, and shuttle 418 of assembly 400-2 may be coupled to display panel portion 14P-2 via screw 416. Shuttle 418 of assembly 400-1 may be coupled to strap 88-1, and shuttle 418 of assembly 400-2 may be coupled to strap 88-2. The end of lever 404 may be slidably coupled to an adjustment screw such as screw 408. Lever 404 may have an opening that receives shaft 412 of screw 408. Screw 408 of assembly 400-1 may be coupled to strap 88-2, and screw 408 of assembly 400-2 may be coupled to strap 88-1.

Spring 406 biases lever 404 away from hinge axis 28H. In the open state of FIG. 17, lever 404 has a surface that contacts shuttle 418 and pushes shuttle 418 away from hinge axis 28H. Lever 404 of assembly 400-1 pushes shuttle 418 in direction 500, which causes shuttle 418 to apply load to display panel portion 14P-1 in direction 500. Similarly, lever 404 of assembly 400-2 pushes shuttle 418 in direction 502, which causes shuttle 418 to apply load to display panel portion 14P-2 in direction 502. In the fully open state of FIG. 17, straps 88-1 and 88-2 are not under tension because lever 404 is not applying any load to screw 408.

As device 10 moves from the fully open state of FIG. 17 to a partially open state, shuttle 418 may continue to move outwardly away from hinge axis 28H and lever 404 may move along shaft 412 until reaching surface 420 of screw 408. Upon reaching surface 420 of screw 408, some of the load of spring 406 may be transferred to screw 408. The load on screw 408 of assembly 400-1 causes screw 408 to pull strap 88-2 in direction 500. The load on screw 408 of assembly 400-2 causes screw 408 to pull strap 88-1 in direction 502. In a partially open state (e.g., where housing portions 12-1 and 12-2 are separated by 170°, 165°, or other suitable angle), loading on display may be balanced between the tension on straps 88-1 and 88-2 (which tends to pull display panel portions 14P-1 and 14P-2 into hinge 30) and direct loading via levers 402 acting on shuttles 418 (which tends to push display panel portions 14P-1 and 14P-2 away from hinge 30).

As device 10 moves from a partially open state to a closed state, shuttle 318 may continue to move outwardly away from hinge axis 28H until lever 404 is no longer applying load to shuttle 418 and is only applying load to screw 408. The load on screw 408 of assembly 400-1 causes screw 408 to pull strap 88-2 in direction 500. The load on screw 408 of assembly 400-2 causes screw 408 to pull strap 88-1 in direction 502. As device 10 moves to a fully closed state (e.g., as the angle between housing portions 12-1 and 12-2 changes from 160° to 0°, or other suitable angle), loading on display 14 may be dominated by the tension on straps 88-1 and 88-2. Strap 88-1 may pull display panel portion 14P-1 in direction 502 towards hinge 30, and strap 88-2 may pull display panel portion 14P-2 in direction 500 towards hinge 30, thereby placing display 14 under compression to prevent tenting and lift-off of display 14 relative to the hinge 30.

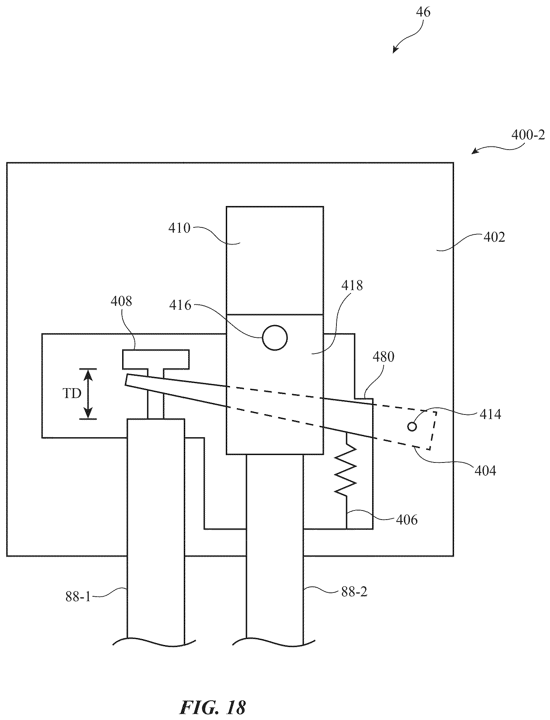

FIG. 18 is a top view of an illustrative tension and compression module 46 that may be used in the system of FIG. 17. In the example of FIG. 18, the neutral axis of straps 88-1 and 88-2 relative to display 14 may be positioned such that straps 88-1 and 88-2 travel slightly more than display 14 as device 10 moves from an open position to a closed position. This overtravel may result in lever 404 reaching its limit of rotation away from hinge 30 just as device 10 is fully closed. As shown in FIG. 18, lever 404 may rotate about pivot point 414 until hard stop 480 is reached at the fully closed position. When lever 404 reaches hard stop 480, the load may be removed from strap 88-1 and 88-2, which in turn relieves compressive load on display 14 when device 10 is in the closed position. This may help avoid long term loading on display 14, as device 10 may be closed and/or stored away for extended periods of time.

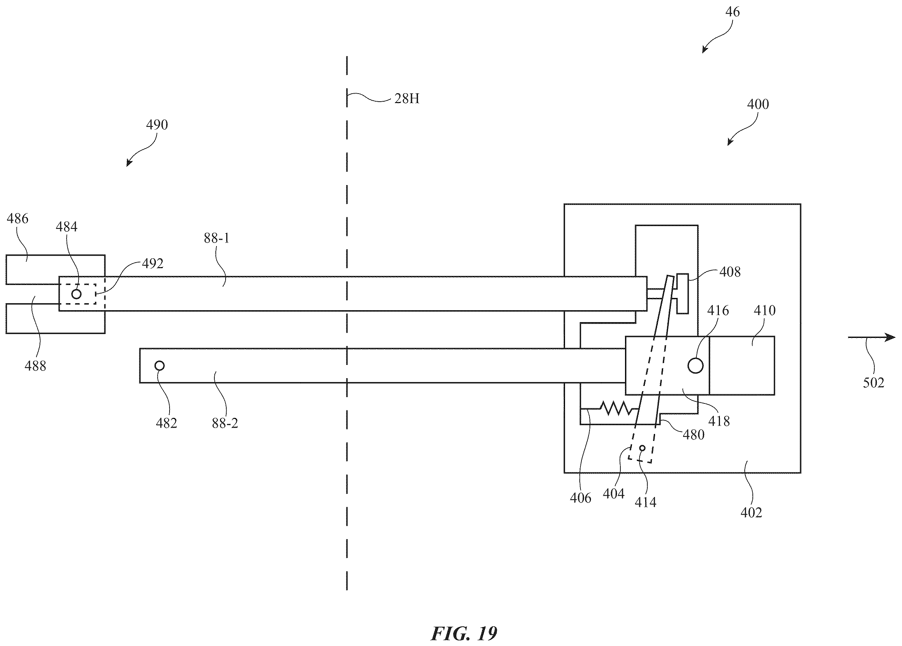

FIG. 19 is a top view of an illustrative tension and compression module 46 that may be used to apply tension and compression to display 14. The arrangement of FIG. 19 is similar to that of FIG. 17 except that the spring loaded lever 404 on one side of each module 46 is eliminated. The remaining spring loaded lever 404 may provide both tension and compression for both sides of display 14. Additionally, the arrangement of FIG. 19 may allow for a known position of display 14 relative to housing 12, as the display position of FIG. 19 does not rely on the balance of two springs to center display 14 relative to housing 12.

Tension and compression module 46 may include assembly 400 mounted to housing portion 12-1 and assembly 490 mounted to housing portion 12-2. Straps 88-1 and 88-2 may be coupled between assemblies 400 and 490 and may extend across hinge axis 28H. Device 10 may include one or more additional tension and compression modules 46 of the type shown in FIG. 19. For example, device 10 may include a second tension and compression module 46 that is identical to that of FIG. 19 but with geometry that is mirrored across hinge axis 28H.

Strap 88-1 may be coupled to pin 484 which is in turn coupled to display portion 14P-2. Pin 484 may be configured to slide within channel 488 (e.g., a groove, slot, etc.) of support structure 486 (e.g., a support structure that is fixed relative to housing portion 12-1. Strap 88-2 may be coupled to pin 482 which is fixed relative to housing portion 12-1.

When device 10 is in the closed position of FIG. 19, lever 408 is against hard stop 480, which unloads strap 88-1, strap 88-2, and display 14, as discussed in connection with FIG. 18. As device 10 moves from the closed position of FIG. 19 to a partially open position (e.g., a partially open position in which the angle between housing portions 12-1 and 12-2 is greater than 0° and less than 180°), compression spring 406 may push against lever 404 which loads strap 88-1. Strap 88-1 is coupled to display portion 14P-2 via pin 484. As lever 404 loads strap 88-1, strap 88-1 may pull display portion 14P-2 towards hinge axis 28H. As device 10 approaches a fully open position (e.g., when the angle between housing portions 12-1 and 12-2 is about 170° or some other suitable angle), pin 484 may reach hard stop 492 and shuttle 418 may contact lever 404, which unloads straps 88-1 and 88-2. Spring 406 may push against display portion 14P-1, which helps maintain tension on display 14 when device 10 is in a fully open position (e.g., when the angle between housing portions 12-1 and 12-2 is 180°).

Device 10 may be operated in a system that uses personally identifiable information. It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

In accordance with an aspect of the invention, an electronic device includes a flexible display having first and second display portions that rotate relative to one another about a bend axis, a foldable housing having first and second housing portions coupled by a hinge that overlaps the bend axis, where the foldable housing is operable in a flat state and a folded state, a tension assembly that applies tension to the flexible display when the foldable housing is in the flat state, and a compression assembly that applies compression to the flexible display when the foldable housing is in the folded state.

Preferably, each of the tension and compression assemblies optionally includes a spring and a slider that slides the flexible display relative to the foldable housing.

The tension assembly optionally only applies the tension to the flexible display when an angle between the first and second housing portions is greater than a threshold angle.

The electronic device optionally further includes a translation assembly that includes a strap that extends across the hinge, where the strap has a first end coupled to the first display portion and the first housing portion through a linkage and has a second opposing end coupled to the second housing portion, and where the linkage is configured to slide the first display portion relative to the first housing portion as the foldable housing moves between the flat state and the folded state.

The linkage optionally includes a lever and the lever is configured to rotate relative to the first housing portion about a first pivot point, the strap is coupled to the lever at a second pivot point, the first display portion is coupled to the lever at a third pivot point, and a distance between the first and second pivot points is less than a distance between the first and third pivot points.

The electronic device optionally further includes an additional strap coupled to the lever at a fourth pivot point, where the strap and the additional strap are located at different offsets relative to a center of rotation of the hinge.

The linkage optionally includes a lever and the strap and the lever are coupled to a slider that is coupled to the first display portion and that slides within a slot in the first housing portion.

The electronic device optionally further includes a spring coupled to the first end of the strap.

Tension and compression assemblies are optionally configured to apply unequal loads to the first and second display portions such that movement of the flexible display relative to the foldable housing is asymmetric across the bend axis.

The tension and compression assemblies are optionally actuator-driven.

In accordance with an aspect of the invention, an electronic device includes a flexible display having first and second display portions that rotate relative to one another about a bend axis, a foldable housing having first and second housing portions coupled by a hinge aligned with the bend axis, where the foldable housing is operable in a flat state and a folded state, and a strap that extends across the hinge, where the strap has a first end coupled to the first display portion and the first housing portion and has a second opposing end coupled to the second housing portion, and where the strap is configured to slide the first display portion relative to the first housing portion as the foldable housing moves between the flat state and the folded state.

The first end of the strap is optionally coupled to the first display portion and the first housing portion through a lever.

The lever is optionally configured to rotate about a first pivot point, the strap is coupled to the lever at a second pivot point, the first display portion is coupled to the lever at a third pivot point, and a distance between the first and second pivot points is less than a distance between the first and third pivot points.

The first end of the strap is optionally coupled to the first display portion and the first housing portion through a Watts linkage.

The Watts linkage optionally applies compression to the flexible display when the foldable housing is in the folded state.

In accordance with an aspect of the invention, an electronic device includes a flexible display having first and second display portions that rotate relative to one another about a bend axis, a foldable housing having first and second housing portions coupled by a hinge aligned with the bend axis, where the foldable housing is operable in a flat state and a folded state, and an assembly configured to apply tension to the flexible display when the foldable housing is in the flat state.

The assembly optionally includes a Watts linkage.

The assembly optionally begins to apply the tension to the flexible display only when an angle between the first and second housing portions exceeds a threshold angle.

The assembly optionally includes a pre-loaded spring that is compressed when an angle between the first and second housing portions exceeds the threshold angle and a stop structure that carries a load of the pre-loaded spring when the angle between the first and second housing portions is less than the threshold angle, where the load is transferred from the stop structure to the flexible display when the angle between the first and second housing portions exceeds the threshold angle to apply the tension to the flexible display.

The assembly is optionally configured to apply compression to the flexible display when the foldable housing is in the folded state.

The foregoing is merely illustrative and various modifications can be made to the described embodiments. The foregoing embodiments may be implemented individually or in any combination.

## Claims

1. An electronic device, comprising:
a flexible display having first and second display portions that rotate relative to one another about a bend axis;
a foldable housing having first and second housing portions coupled by a hinge that overlaps the bend axis, wherein the foldable housing is operable in a flat state and a folded state;
a tension assembly that applies tension to the flexible display when the foldable housing is in the flat state; and
a compression assembly that applies compression to the flexible display when the foldable housing is in the folded state.

2. The electronic device defined in claim 1 wherein each of the tension and compression assemblies comprises a spring and a slider that slides the flexible display relative to the foldable housing.

3. The electronic device defined in claim 1 or claim 2 wherein the tension assembly only applies the tension to the flexible display when an angle between the first and second housing portions is greater than a threshold angle.

4. The electronic device defined in any preceding claim further comprising a translation assembly comprising:
a strap that extends across the hinge, wherein the strap has a first end coupled to the first display portion and the first housing portion through a linkage and has a second opposing end coupled to the second housing portion, and wherein the linkage is configured to slide the first display portion relative to the first housing portion as the foldable housing moves between the flat state and the folded state.

5. The electronic device defined in claim 4 wherein the linkage comprises a lever and wherein the lever is configured to rotate relative to the first housing portion about a first pivot point, the strap is coupled to the lever at a second pivot point, the first display portion is coupled to the lever at a third pivot point, and a distance between the first and second pivot points is less than a distance between the first and third pivot points.

6. The electronic device defined in claim 5 further comprising an additional strap coupled to the lever at a fourth pivot point, wherein the strap and the additional strap are located at different offsets relative to a center of rotation of the hinge.

7. The electronic device defined in claim 4 wherein the linkage comprises a lever and wherein the strap and the lever are coupled to a slider that is coupled to the first display portion and that slides within a slot in the first housing portion.

8. The electronic device defined in any of claims 4 to 7 further comprising a spring coupled to the first end of the strap.

9. The electronic device defined in any preceding claim wherein tension and compression assemblies are configured to apply unequal loads to the first and second display portions such that movement of the flexible display relative to the foldable housing is asymmetric across the bend axis.

10. The electronic device defined in any preceding claim wherein the tension and compression assemblies are actuator-driven.

11. The electronic device defined in any of claims 1 to 3 further comprising:
a strap that extends across the hinge, wherein the strap has a first end coupled to the first display portion and the first housing portion and has a second opposing end coupled to the second housing portion, and wherein the strap is configured to slide the first display portion relative to the first housing portion as the foldable housing moves between the flat state and the folded state.

12. The electronic device defined in claim 11 wherein the first end of the strap is coupled to the first display portion and the first housing portion through a lever.

13. The electronic device defined in claim 12 wherein the lever is configured to rotate about a first pivot point, the strap is coupled to the lever at a second pivot point, the first display portion is coupled to the lever at a third pivot point, and a distance between the first and second pivot points is less than a distance between the first and third pivot points.

14. The electronic device defined in claim 11 wherein the first end of the strap is coupled to the first display portion and the first housing portion through a Watts linkage.

15. The electronic device defined in claim 14 wherein the Watts linkage applies compression to the flexible display when the foldable housing is in the folded state.
